# EUROPEAN PATENT SPECIFICATION

(11) **EP 2 685 344 B1**
(45) Date of publication and mention of the grant of the patent: **04.12.2019**
(21) Application number: 13152478.7
(22) Date of filing: 24.01.2013
(51) Int. Cl.: G06F 1/16, H05K 7/00, F16M 11/10

(54) **Collapsible electronic equipment**
Zusammenklappbares elektronisches Gerät
Équipement électronique pliable

(30) Priority: 09.07.2012 TW 101124577
(43) Date of publication of application: 15.01.2014
(73) Proprietor: Acer Incorporated, Taipei Hsien 221 (TW)
(72) Inventor: Huang, Kai-Hung, Taipei Hsien 221 (TW)
(74) Representative: Becker Kurig Straus

(56) References cited:
- US-A1- 2007 025 853
- US-A1- 2008 136 610
- US-A1- 2008 170 358

## Description

### CROSS-REFERENCE TO RELATED APPLICATIONS

This Application claims priority of Taiwan Patent Application No. 101124577, filed on Jul. 9, 2012.

### BACKGROUND OF THE INVENTION

### Field of the Invention

The present invention relates to an electronic equipment, and in particular, to a collapsible electronic equipment.

### Description of the Related Art

In recent years, since touch displays are very popular, users are accustomed to controlling electronic equipment by touching. Thus, many notebook computers are provided with touch functions via touch displays, such as rotatable touch displays.

However, a conventional hinge of the notebook computer does not allow the touch display to rotate to the rear side of a mainframe thereof. Thus, in the conventional art, a dual-axis hinge is utilized to allow the touch display to rotate to a rear side of the mainframe. However, the structure of the dual-axis hinge is very complex, and the manufacturing cost is high. Moreover, the process of the display rotating to a rear side of the mainframe is not smooth, hindering usage of the notebook computer.

US 2008/170358 A1 discloses an electronic equipment having rotating shaft supporting means provided with a rotating shaft shifting means for shifting a rotating shaft by a predetermined distance in a predetermined direction when a display means is rotated on the rotating shaft to a predetermined angle. The rotating shaft of the display means is electrically driven.

US 2007/025853 A1 discloses a portable multimedia player which comprises a panel, a base, and an electric swiveling mechanism for two axes combining the panel and the base. The electric swiveling mechanism further comprises a first swiveling mechanism and a second swiveling mechanism for controlling yaw and pitch swiveling, respectively.

WO 2007/029546 A1 discloses two-axis hinge device in which a first housing and a second housing that are joined by a hinge can be opened into varied states and the degree of freedom of the rotation angle of the first housing and the second housing when they are rotated is increased. Two open/close shafts are placed to join the first housing and the second housing in an openable/closable manner. A torque unit is formed such that fixed cams and rotating cams inserted in the open/close shafts are in contact with each other at contact cam surfaces to generate sliding friction torque or click torque when the open/close shafts are rotated.

US2008136610 A1 discloses a central video screen for a vehicle comprising a TV set and a drive mechanism installed on a base bracket, where the screen is installed on the base bracket through a rotating shaft with a limit buffering plate. A control module receives and transmits a control signal. The module controls rotation of an electrical motor, and turns the rotating shaft through the drive mechanism to realize ascending, descending, and overturning of the screen.

### BRIEF SUMMARY OF THE INVENTION

The present invention is provided by appended claim 1. Beneficial embodiments are provided in the dependent claims. Accordingly, to solve the problems of the prior art, the object of the present invention provides a collapsible electronic equipment with a hinge device. The structure of the hinge device is simple, and a display of the collapsible electronic equipment is rotated smoothly to a rear side of a mainframe thereof.

The present invention provides collapsible electronic equipment comprising: a first part having a front surface and a rear surface opposite to the front surface; a hinge device disposed on the first part and including a shaft rotating about an axis along a third direction parallel to an edge of the first part; and a second part connected to the shaft, the second part is rotatable relative to the first part via the hinge device to cover the front surface in a covering position and to cover the rear surface in a rear position. The hinge device comprises a shifting mechanism, wherein the shaft is pivoted on the shifting mechanism; and a driving mechanism coupled to the shifting mechanism. The driving mechanism is adapted to drive the shifting mechanism and the shaft to move up and down between a first and second position along the second direction perpendicular to the third direction of the rotation axis of the shaft when the second part is located at an inclined angle between 90 degrees and 270 degrees relative to the first part, wherein in the first position, the second part may be rotated via the shaft to take the cover position to cover the front surface of the first part, and wherein in the second position the second part is able to rotate via the shaft to take the rear position to cover the rear surface of the first part..

When the second part covers the front surface, the shifting mechanism and the shaft are located at a first position. When the second part is located at an inclined position with an inclined angle relative to the first part, the driving mechanism drives the shifting mechanism to force the shaft to move from the first position to a second position, or move from the second position to the first position. When the second part is located at a rear side, relative to the rear surface, of the first part, the shifting mechanism and the shaft are located at the second position.

In conclusion, the structure of the hinge device of the collapsible electronic equipment is simple, and thus the manufacturing cost is decreased. Moreover, the display is rotated smoothly, making the collapsible electronic equipment more convenient to use.

### BRIEF DESCRIPTION OF THE DRAWINGS

The invention can be more fully understood by reading the subsequent detailed description and examples with references made to the accompanying drawings, wherein:
Fig. 1 is a perspective view of a collapsible electronic equipment according to the present invention;
Fig. 2 is a perspective view of a hinge device according to the present invention;
Fig. 3 is a exploded view of the hinge device according to the present invention;
Fig. 4 is a cross-sectional view of the collapsible electronic equipment according to the present invention; and
Figs. 5 to 7 are schematic view of the collapsible electronic equipment in a moving process according to the present invention.

### DETAILED DESCRIPTION OF THE INVENTION

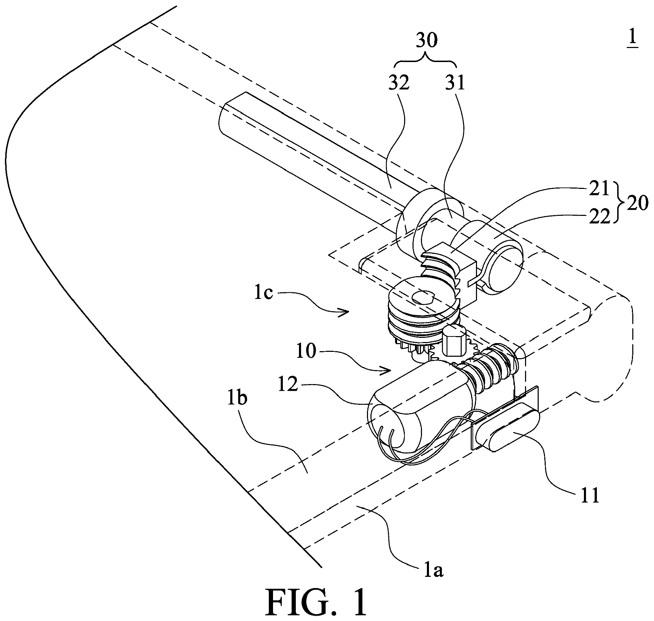

Fig. 1 is a perspective view of a collapsible electronic equipment 1 according to the present invention. The collapsible electronic equipment 1 may be a notebook computer. The collapsible electronic equipment 1 includes a first part 1a, a second part 1b, and a hinge device 1c. The first part 1a may be a mainframe including electronic elements, such as a keyboard, a touch panel, a touch display, a central processing unit (CPU), a memory, and a motherboard. The second part 1b may be a display, such as a touch display. The hinge device 1c is disposed on the first part 1a and the second part 1b, and the second part 1b is rotatable relative to the first part 1a via the hinge device 1c.

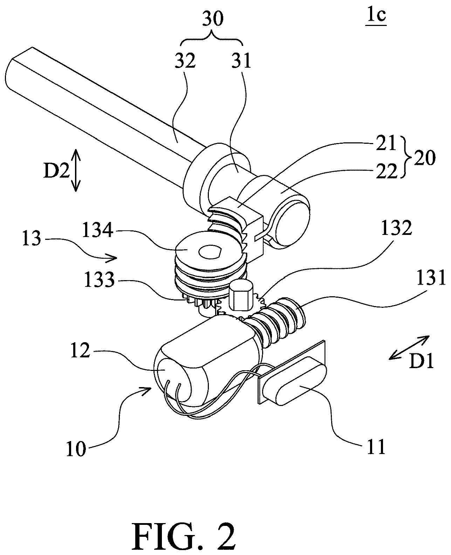

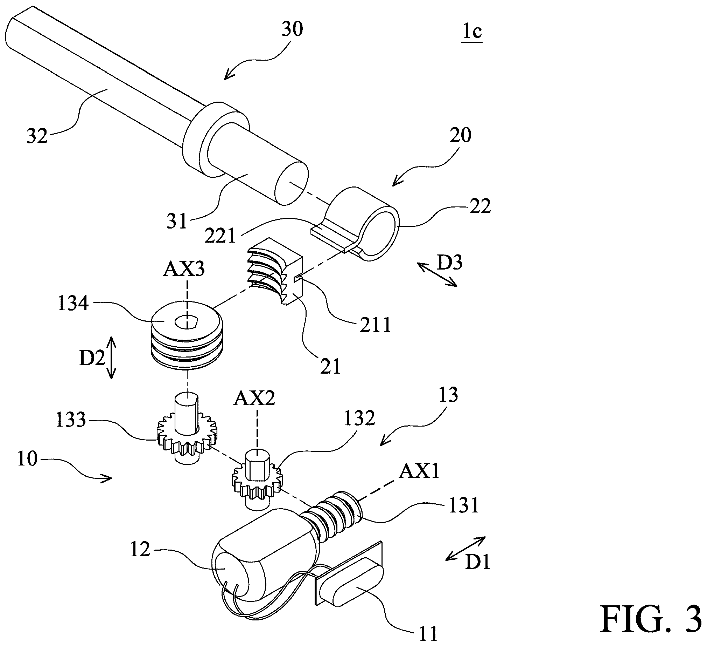

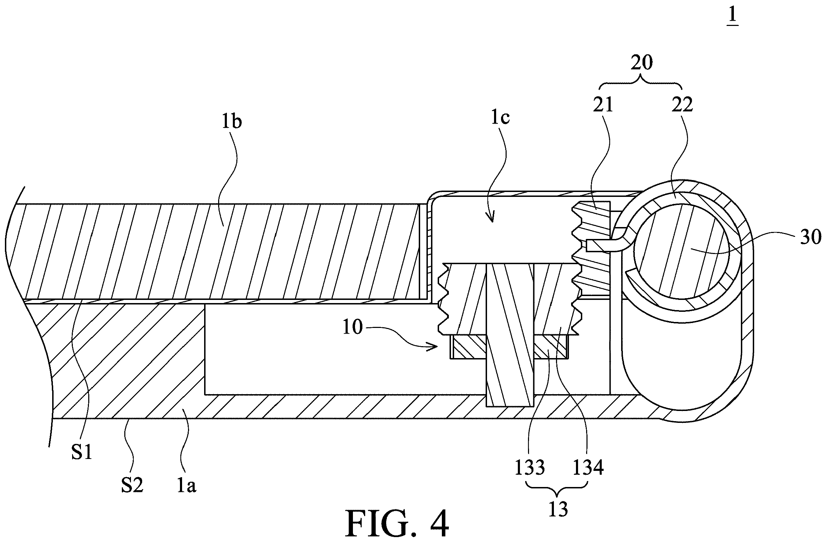

Fig. 2 is a perspective view of a hinge device 1c according to the present invention. Fig. 3 is an exploded view of the hinge device 1c according to the present invention. Fig. 4 is a cross-sectional view of the collapsible electronic equipment 1 according to the present invention. The hinge device 1c includes a driving mechanism 10, a shifting mechanism 20, and a shaft 30. The driving mechanism 10 is disposed on the first part 1a. The shifting mechanism 20 is movable disposed on the driving mechanism 10. The shaft 30 is pivoted on the shifting mechanism 20. The second part 1b is fixed on the shaft 30, and rotatable relative to the first part 1a via the shaft 30.

The driving mechanism 10 includes a switch 11, a motor 12, and a gear set 13. The switch 11 is coupled to the motor 12. The switch 11 generates a switch signal according to a touching event. The motor 12 is enabled in forward or reverse rotation according to the switch signal, and drives the gear set 13 to rotate. The touching event may be generated by a user pressing the switch 11.

In another embodiment, the switch 11 may be excluded. For example, the motor 12 is controlled by a processing chip (not shown in figures) of the collapsible electronic equipment 1 which detects an inclined angle between the second part 1b and the first part 1a.

The gear set 13 includes a first worm gear 131, a first spur gear 132, a second spur gear 133, and a second worm gear 134. The first worm gear 131 is connected with the motor 12, and rotated about an axis AX1. The axis AX1 is extended along a first direction D1. The first spur gear 132 is engaged with the first worm gear 131, and is rotated about an axis AX2. The second spur gear 133 is engaged with the first spur gear 132, and is rotated about an axis AX3. The second worm gear 134 and second spur gear 133 have the same axis, and the second worm gear 134 is engaged with the shifting mechanism 20. The axis AX2 and axis AX3 are extended along a second direction D2, and the first direction D1 is perpendicular to the second direction D2.

By the described structure of the gear set 13, the driving mechanism 10 is able to be disposed in a thin collapsible electronic equipment. However, the gear set 13 has various embodiments, and the present invention is not limited by the described gear set 13.

The shifting mechanism 20 includes a gear rack 21 and a fixing element 22. The gear rack 21 is engaged with the second worm gear 134 of the gear set 13, and may be moved up or down along the second direction D2. The gear rack 21 has a fixing groove 211. The fixing element 22 is a ring structure, and pivoted on the shaft 30. The fixing element 22 has a retaining portion 221 fixed in the fixing groove 211 of the gear rack 21.

The shaft 30 includes a pivot portion 31 and a fixing portion 32 disposed on the pivot portion 31. The pivot portion 31 and the fixing portion 32 are extended along a third direction D3. The first direction D1, the second direction D2 and the third direction D3 are perpendicular to each other. The second part 1b is fixed on fixing portion 32, and the fixing element 22 is disposed and pivoted on the pivot portion 31. Thus, the second part 1b is rotatable relative to the first part 1a.

In the embodiment, when the motor 12 is enabled in forward rotation, the gear rack 21 is moved up along the second direction D2, and the shifting mechanism 20 and the shaft 30 are located at a first position. When the motor 12 is enabled in reverse rotation, the gear rack 21 is moved down along the second direction D2, and the shifting mechanism 20 and the shaft 30 are located at a second position. A mechanism, which controls the motor 12 enabled in forward or reverse rotation or disabled, is well known in this art, and the detailed descriptions thereof are not provided.

As shown in Fig. 4, the first part 1a has a front surface S1, and a rear surface S2 opposite to the front surface S1. When the second part 1b covers to the front surface S1 at a covering position, the shifting mechanism 20 and the shaft 30 are located at the first position. Thus, the second part 1b is able to cover the front surface S1 since the shaft 30 is protruding over the front surface S1.

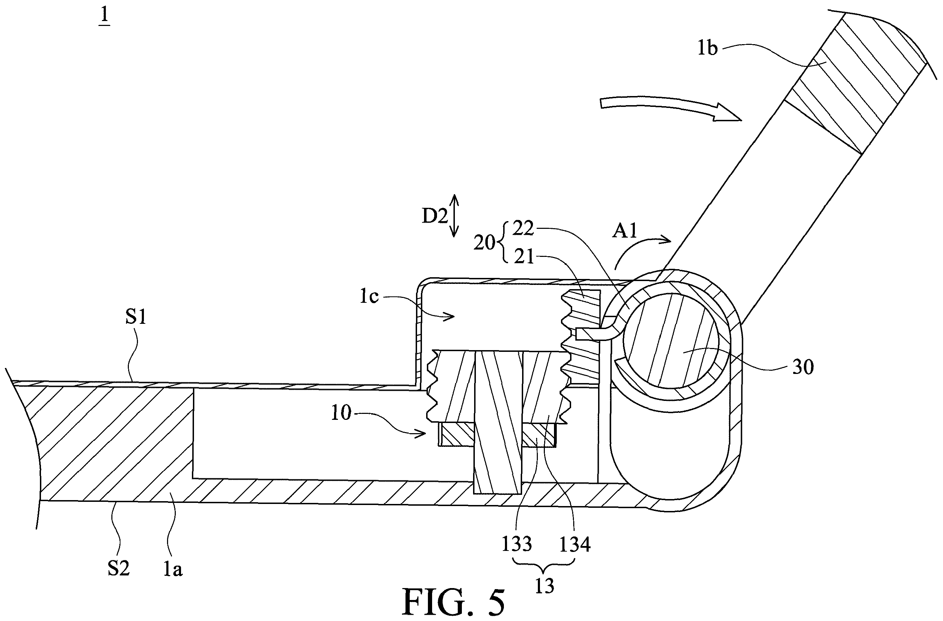

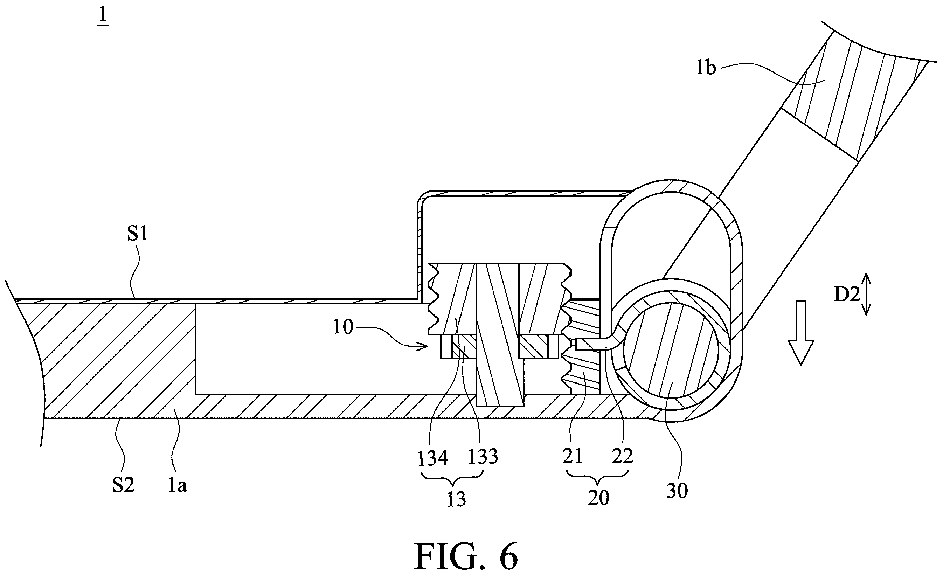

As shown in Fig. 5, when the second part 1b is located at an inclined position with an inclined angle A1 relative to the first part 1a, the shifting mechanism 20 and the shaft 30 are located at a first position. The collapsible electronic equipment 1 may be used as a notebook computer. Next, when the second part 1b is continuously rotated, the driving mechanism 10 may drive the shifting mechanism 20 to force the shaft 30 to move from the first position to the second position (as shown in Fig. 6). In the embodiment, the inclined angle A1 is between 90 degrees to 270 degrees.

Specifically, when the second part 1b is moved from the covering position to the inclined position, the driving mechanism 10 is enabled, and the second worm gear 134 of the driving mechanism 10 is rotated. Next, the second worm gear 134 moves the gear rack 21 of the shifting mechanism 20 down along the second direction D2, and the fixing element 22 and the shaft 30 is moved from the first position to the second position.

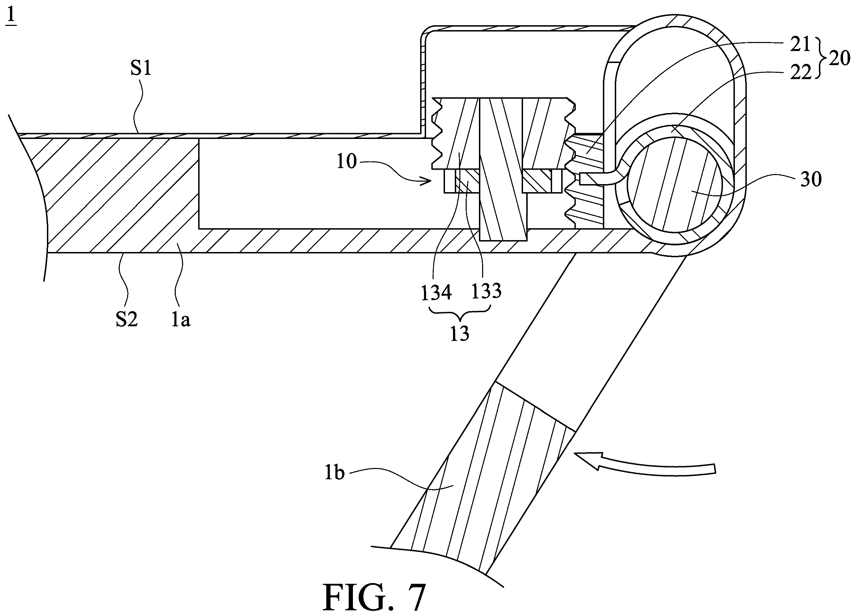

As shown in Figs. 6 and 7, when the shifting mechanism 20 and the shaft 30 are located at the second position, the shaft 30 is protruded over or close to the rear surface S2, and the second part 1b is able to rotate to cover the rear surface S2 of the first part 1a. The collapsible electronic equipment 1 may be used as a tablet computer. Alternately, the second part 1b may be located at a rear position (at a rear side of the first part 1a as shown in Fig. 7), and then the front surface S1 of the first part 1a may be disposed on a surface, such as tabletop for convenience of operating the second part 1b. The rear side is relative to the rear surface S2, and a front side of the first part 1a is relative to the front surface S1.

Similarly, when the second part 1b is moved from the covering position (as shown in Fig. 4) or the rear position (as shown in Fig. 7) to the inclined position with the inclined angle A1 as shown in Fig. 5 (or with another inclined angle between 90 degrees and 270 degrees), the driving mechanism 10 is enabled, and the second worm gear 134 of the driving mechanism 10 is rotated. Next, the second worm gear 134 drives the gear rack 21 of the shifting mechanism 20 to move up along the second direction D2, and thus the fixing element 22 and the shaft 30 is moved from the second position (as shown in Fig. 6) to the first position (as shown in Fig. 5).

Since the first part 1a and the second part 1b are pivoted with one shaft 30, the second part 1b is smoothly rotated relative to the first part 1a.

In another embodiment, the driving mechanism 10 and the shifting mechanism 20 may be further simplified. For example, some elements of the gear set 13, the switch 11 and the motor 12 of the driving mechanism 10, and the gear rack 21 of the shifting mechanism 20 may be excluded. The driving mechanism 10 includes connecting rods, and the driving mechanism 10 is controlled manually to move the fixing element 22 of the shifting mechanism 20 to let the shifting mechanism 20 and the shaft 30 move up or down along the second direction D2.

In conclusion, the structure of the hinge device of the collapsible electronic equipment of the present invention is simple, and thus the manufacturing cost is decreased. Moreover, the display is rotated smoothly, making the collapsible electronic equipment more convenient to use.

While the invention has been described by way of example and in terms of preferred embodiment, it is to be understood that the invention is not limited thereto. To the contrary, it is intended to cover various modifications and similar arrangements (as would be apparent to those skilled in the art) without departing from the scope of the appended claims.

## Claims

1. A collapsible electronic equipment (1), comprising:
a first part (1a) having a front surface (S1) and a rear surface (S2) opposite to the front surface (S1);
a hinge device (1c) disposed on the first part (1a) and including a shaft (30) rotating about an axis along a third direction (D3) parallel to an edge of the first part (1a); and
a second part (1b) fixed on the shaft (30), the second part (1b) is rotatable relative to the first part (1a) via the shaft (30) to cover the front surface (S1) in a covering position and to cover the rear surface (S2) in a rear position; **characterized in that** the hinge device (1c) further comprises:
a shifting mechanism (20), wherein the shaft (30) is pivotable on the shifting mechanism (20); and
a driving mechanism (10) coupled to the shifting mechanism (20), (1a); wherein the driving mechanism (10) is adapted to drive the shifting mechanism (20) together with the shaft (30) to move up and down between a first and a second position along the second direction (D2) perpendicular to the third direction (D3) of the rotation axis of the shaft (30) when the second part (1b) is located at an inclined angle between 90 degrees and 270 degrees relative to the first part (1a), wherein
in the first position, the second part (1b) is able to rotate via the shaft (30) to take the covering position to cover the front surface (S1) of the first part (1a), and
wherein in the second position the second part (1b) is able to rotate via the shaft (30) to take the rear position to cover the rear surface (S2) of the first part (1a).

2. The collapsible electronic equipment (1) as claimed in claim 1,
wherein the driving mechanism (10) includes a motor (12) and a gear set (13), and the motor is configured to drive the gear set rotating.

3. The collapsible electronic equipment (1) as claimed in claim 2,
wherein the driving mechanism (10) further comprises a switch (11) coupled to the motor (12).

4. The collapsible electronic equipment (1) as claimed in claim 2, wherein the shifting mechanism (20) further comprises a gear rack (21) and a fixing element (22), and the gear rack (21) is engaged with the gear set (13), and the fixing element (22) is disposed on the gear rack (21) and is pivotable on the shaft (30).

5. The collapsible electronic equipment (1) as claimed in claim 4,
wherein the gear set (13) comprises:
a first worm gear (131) connected with the motor (12);
a first spur gear (132) engaged with the first worm gear (131)
a second spur gear (133) engaged with the first spur gear (132); and
a second worm gear (134) engaged with the gear rack (13), wherein the second worm gear (134) and the second spur gear (133) have the same axis (AX3).

6. The collapsible electronic equipment (1) as claimed in claim 1, wherein the first part (1a) is a mainframe, and the second part (1b) is a display.

## Patentansprüche

1. Zusammenklappbares elektronisches Gerät (1), umfassend:
einen ersten Teil (la), der eine vordere Oberfläche (S1) und eine hintere Oberfläche (S2) aufweist,
die der vordere Oberfläche (S1) gegenüberliegt;
eine Scharniervorrichtung (1c), die auf dem ersten Teil (1a) angeordnet ist und eine Welle (30) beinhaltet,
die um eine Achse entlang einer dritten Richtung (D3) parallel zu einer Kante des ersten Teils (1a) rotiert; und
einen zweiten Teil (1b), der an der Welle (30) befestigt ist, wobei der zweite Teil (1b) relativ zu dem ersten Teil (1a) über die Welle (30) rotierbar ist,
um die vordere Oberfläche (S1) in einer Abdeckposition abzudecken und die hintere Oberfläche (S2) in einer hinteren Position abzudecken; **dadurch gekennzeichnet, dass** die Scharniervorrichtung (1c) weiterhin umfasst:
einen Verschiebemechanismus (20), wobei die Welle (30) auf dem Verschiebemechanismus (20) schwenkbar ist; und
einen Antriebsmechanismus (10), der mit dem Verschiebemechanismus (20), (1a) gekoppelt ist; wobei der Antriebsmechanismus (10) angepasst ist, um den Verschiebemechanismus (20) zusammen mit der Welle (30)
anzutreiben, um sich zwischen einer ersten und einer zweiten Position entlang der zweiten Richtung (D2) senkrecht zur dritten Richtung (D3) der Rotationsachse der Welle (30) auf und ab zu bewegen, wenn der zweite Teil (1b) sich in einem geneigten Winkel
zwischen 90 Grad und 270 Grad befindet relativ zum ersten Teil (la), wobei
in der ersten Position, der zweite Teil (1b) über die Welle (30) rotieren kann, um die Abdeckposition einzunehmen, um die vordere Oberfläche (S1) des ersten Teils (1a) abzudecken, und
wobei in der zweiten Position, der zweite Teil (1b) über die Welle (30) rotieren kann, um die hintere Position einzunehmen, um die hintere Oberfläche (S2) des ersten Teils (1a) abzudecken.

2. Zusammenklappbares elektronisches Gerät (1) gemäß Anspruch 1, wobei der Antriebsmechanismus (10) einen Motor (12) und einen Radsatz (13) beinhaltet und der Motor konfiguriert ist, den Radsatz zum Rotieren anzutreiben.

3. Zusammenklappbares elektronisches Gerät (1) gemäß Anspruch 2, wobei der Antriebsmechanismus (10) weiterhin einen Schalter (11) umfasst, der mit dem Motor (12) gekoppelt ist.

4. Zusammenklappbares elektronisches Gerät (1) gemäß Anspruch 2, wobei der Verschiebemechanismus (20) weiterhin eine Zahnstange (21) und ein Befestigungselement (22) umfasst, und wobei die Zahnstange (21) mit dem Radsatz (13) in Eingriff steht, und wobei das Befestigungselement (22) auf der Zahnstange (21) angeordnet ist und auf der Welle (30) schwenkbar ist.

5. Zusammenklappbares elektronisches Gerät (1) gemäß Anspruch 4, wobei der Radsatz (13) umfasst:
ein erstes Schneckenrad (131), das mit dem Motor (12) verbunden ist;
ein erstes Stirnrad (132), das mit dem ersten Schneckenrad (131) in Eingriff steht;
ein zweites Stirnrad (133), das mit dem ersten Stirnrad (132) in Eingriff steht; und
ein zweites Schneckenrad (134), das mit der Zahnstange (13) in Eingriff steht, wobei das zweite Schneckenrad (134) und das zweite Stirnrad (133) die gleiche Achse (AX3) aufweisen.

6. Zusammenklappbares elektronisches Gerät (1) gemäß Anspruch 1, wobei der erste Teil (1a) ein Hauptrahmen ist und der zweite Teil (1b) eine Anzeige ist.

## Revendications

1. Équipement électronique pliable (1), comprenant :
une première partie (1a) ayant une surface avant (S1) et une surface arrière (S2) opposée à la surface avant (S1) ;
un dispositif de charnière (1c) disposé sur la première partie (1a) et incluant un axe (30) tournant rotativement autour d'un axe le long d'une troisième direction (D3) parallèle à un bord de la première partie (1a) ; et
une seconde partie (1b) fixée sur l'axe (30), la seconde partie (1b) est rotative par rapport à la première partie (1a) via l'axe (30) pour couvrir la surface avant (S1) dans une position de couverture et couvrir la surface arrière (S2) dans une position arrière, **caractérisé en ce que** le dispositif de charnière (1c) comprend en outre :
un mécanisme de déplacement (20), dans lequel l'axe (30) est pilotable sur le mécanisme de déplacement (20) ; et
un mécanisme d'entraînement (10) couplé au mécanisme de déplacement (20) (1a) ; dans lequel le mécanisme d'entraînement (10) est adapté pour entraîner le mécanisme de déplacement (20) conjointement à l'arbre (30) afin de se déplacer vers le haut et vers le bas entre une première et une seconde position le long de la seconde direction (D2) perpendiculaire à la troisième direction (D3) de l'axe de rotation de l'arbre (30) lorsque la seconde partie (1b) est situé à un angle incliné entre 90° et 270° par rapport à la première partie (la), dans lequel dans la première position, la seconde partie (1b) est capable de tourner rotativement via l'arbre (30) afin d'adopter la position de couverture pour couvrir la surface avant (S1) de la première partie (1a), et
dans lequel dans la seconde position, la seconde partie (1b) est capable de tourner rotativement via l'arbre (30) afin d'adopter la position arrière pour couvrir la surface arrière (S2) de la première partie (1a).

2. Équipement électronique pliable (1) selon la revendication 1, dans lequel le mécanisme d'entraînement (10) inclut un moteur (12) et un train d'engrenage (13), et le moteur est configuré pour entraîner en rotation le train d'engrenage.

3. Équipement électronique pliable (1) selon la revendication 2, dans lequel le mécanisme d'entraînement (10) comprend en outre un commutateur (11) couplé au moteur (12).

4. Équipement électronique pliable (1) selon la revendication 2, dans lequel le mécanisme de déplacement (20) comprend en outre une crémaillère (21) et un élément de fixation (22), et la crémaillère (21) vient en prise avec le train d'engrenage (13), et l'élément de fixation (22) est disposé sur la crémaillère (21) et est pivotable sur l'arbre (30).

5. Équipement électronique pliable (1) selon la revendication 4, dans lequel le train d'engrenage (13) comprend :
un premier engrenage à vis sans fin (131) raccordé au moteur (12) ;
un premier engrenage droit (132) raccordé au premier engrenage à vis sans fin (131) ;
un second engrenage droit (133) raccordé au premier engrenage droit (132) ; et
un second engrenage à vis sans fin (134) raccordé au train d'engrenage (13), dans lequel le second engrenage à vis sans fin (134) et le second engrenage droit (133) ont le même axe (AX3).

6. Équipement électronique pliable (1) selon la revendication, dans lequel la première partie est une unité centrale (1a) et la seconde partie est un écran (1b).
